# FASCICULE DE BREVET EUROPEEN

(11) **EP 3 485 535 B1**
(45) Date de publication et mention de la délivrance du brevet: **13.05.2020**
(21) Numéro de dépôt: 17751030.2
(22) Date de dépôt: 12.07.2017
(51) Int. Cl.: H05K 1/03, H01Q 15/00, H05K 1/02

(54) **STRUCTURE COMPOSITE À CARACTÉRISTIQUES DIÉLECTRIQUES RECONFIGURABLES ET ENSEMBLE COMPRENANT UNE TELLE STRUCTURE COMPOSITE**
VERBUNDSTRUKTUR MIT REKONFIGURIERBAREN DIELEKTRISCHEN EIGENSCHAFTEN UND ANORDNUNG MIT SOLCH EINER VERBUNDSTRUKTUR
COMPOSITE STRUCTURE HAVING RECONFIGURABLE DIELECTRIC CHARACTERISTICS AND ASSEMBLY COMPRISING SUCH A COMPOSITE STRUCTURE

(30) Priorité: 13.07.2016 FR 1601099
(43) Date de publication de la demande: 22.05.2019
(73) Titulaire: Naval Group, 75015 Paris (FR); Université de Rennes I, 35065 Rennes Cedex (FR); Centre National de la Recherche Scientifique, 75016 Paris (FR)
(72) Inventeur: RUBRICE, Kevin, 44340 Bouguenais (FR); CASTEL, Xavier, 22004 Saint-Brieuc (FR); HIMDI, Mohammed, 35042 Rennes Cedex (FR); PARNEIX, Patrick, 44340 Bouguenais (FR)
(74) Mandataire: Lavoix
(86) Numéro de dépôt international: PCT/EP2017/067630
(87) Numéro de publication internationale: WO 2018/011312

(56) Documents cités:
- US-A- 5 739 796
- US-A1- 2004 184 752

## Description

La présente invention concerne une structure composite à caractéristiques diélectriques reconfigurables.

On connait de US 2004/184752 et US 5739796 de telles structures.

L'invention concerne en particulier des structures composites actives multifonctionnelles présentant à la fois une fonction structurelle et une ou plusieurs fonctionnalités dans le domaine des applications hyperfréquences, par exemple en termes de furtivité, de blindage, d'intégration ou de découplage d'antennes, ou une fonction radôme.

Les substrats en matériaux composites, qu'ils soient monolithiques ou sandwichs, sont dotés de caractéristiques diélectriques complexes (partie réelle + partie imaginaire) définies pour une composition donnée de la structure et à une fréquence de travail donnée. Ces caractéristiques diélectriques sont fixes et non reconfigurables dans l'existant.

De tels substrats peuvent être intégrés à un système hyperfréquence constitué par exemple d'un radôme en matériaux composites et de l'antenne hébergée, ou d'un circuit imprimé sur un substrat en matériau composite, ou encore d'une antenne intégrée dans une paroi structurale en matériau composite.

Par exemple, un système hyperfréquence peut être constitué d'une antenne et d'une paroi formée d'un substrat en un matériau composite, qui est par exemple la paroi porteuse de l'antenne ou un radôme. La reconfigurabilité d'un tel système hyperfréquence est en général assurée par l'antenne, via l'utilisation de composants actifs et commandables électriquement tels que des diodes pin, des varicaps, des transistors et/ou des MEMS, le substrat en matériau composite ayant une fonction totalement passive.

Il a été proposé d'utiliser, dans la paroi, des matériaux actifs reconfigurables, par exemple en déposant des couches minces de matériaux versatiles, dont les paramètres diélectriques sont commandables, sur un substrat passif spécifique. La reconfigurabilité du système hyperfréquence est alors assurée non plus par l'antenne elle-même mais par la paroi active.

Une telle solution ne donne pas entièrement satisfaction. Notamment, l'utilisation de telles parois est réservée à une échelle locale, en raison des nombreuses contraintes liées à ces parois qui limitent leur utilisation à plus grande échelle. En particulier, ces parois sont inadaptées pour la réalisation de grandes structures telles que des structures navales.

Un objectif de l'invention est donc de proposer une structure composite ayant des propriétés diélectriques reconfigurables et qui soit adaptée à la fois pour une utilisation en tant que paroi porteuse d'une antenne ou en tant que radôme, et pour une utilisation à grande échelle en tant que panneau structural, notamment d'un porteur naval, terrestre ou aérien.

A cette fin, l'invention a pour objet une structure composite selon la revendication 1.

La structure selon l'invention peut comprendre l'une ou plusieurs des caractéristiques des revendications 2 à 9..

L'invention a par ailleurs pour objet un ensemble selon la revendication 10.

L'invention sera mieux comprise à la lecture de la description qui va suivre, donnée uniquement à titre d'exemple, et faite en se référant aux dessins annexés, sur lesquels :
- la figure 1 est un schéma d'une structure composite selon un premier mode de réalisation, comprenant un substrat composite est réalisé en un matériau composite monolithique;
- la figure 2 est un schéma d'une structure composite selon un deuxième mode de réalisation, comprenant un substrat composite sandwich;
- la figure 3 illustre de manière schématique une âme en nid d'abeilles d'un substrat composite sandwich selon le deuxième mode de réalisation ;
- la figure 4 illustre schématiquement une structure composite selon le premier mode de réalisation, munie d'une ligne microruban et d'un stub ;
- la figure 5 est un graphique illustrant la variation du coefficient de transmission S₂₁ de la structure composite de la figure 4 en fonction de la fréquence et de la température,
- la figure 6 est un agrandissement de la figure 5, centré sur un premier pic de fréquence ;
- la figure 7 est un agrandissement de la figure 5, centré sur un deuxième pic de fréquence ;
- la figure 8 illustre schématiquement une âme en structure alvéolaire de type nid d'abeilles d'un substrat composite sandwich selon le deuxième mode de réalisation, munie de résistances chauffantes ;
- la figure 9 est un graphique illustrant la variation du coefficient de réflexion S₁₁ de l'âme de la figure 8 en fonction de la fréquence et de la température.

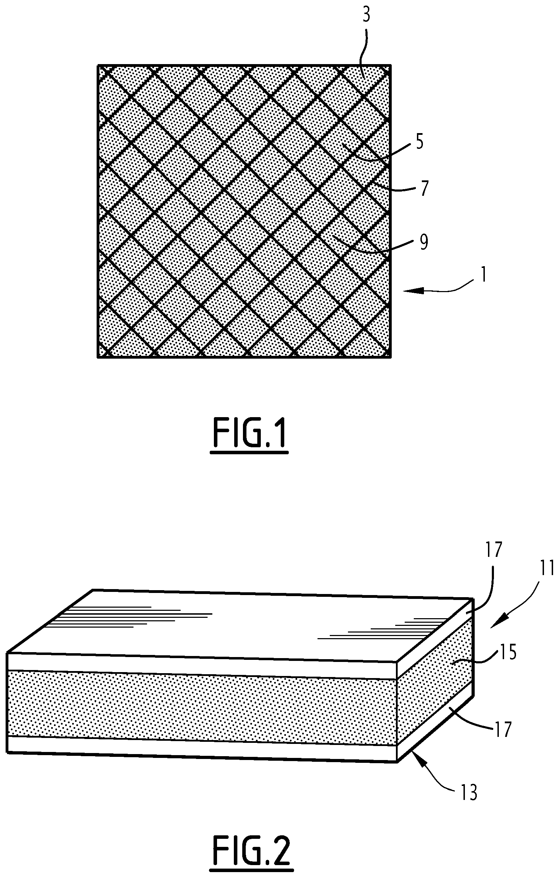

Dans l'ensemble des modes de réalisation décrits en référence aux Figures 1 à 3, la structure composite comprend un substrat composite et une pluralité de charges actives dispersées dans le substrat composite.

Les charges actives sont formées d'un matériau piézoélectrique, dont les caractéristiques diélectriques sont modifiables par application d'une commande à la structure composite, donc aux charges actives. Le matériau piézoélectrique est par exemple également pyroélectrique, i.e. piézoélectrique et pyroélectrique. Le matériau piézoélectrique peut être en outre être ferroélectrique, i.e. être piézoélectrique, pyroélectrique et ferroélectrique.

De ce fait, les caractéristiques diélectriques de la structure composite incluant ces charges sont elles-mêmes modifiables, donc reconfigurables, par application de cette commande.

En particulier, les charges actives sont caractérisées par une permittivité diélectrique complexe *ε** = *ε*'+ *jε*", où ε' et ε" sont respectivement la composante réelle et la composante imaginaire de la permittivité électrique complexe ε* du matériau constituant les charges actives.

Le facteur ou tangente de pertes tan δ de ces charges actives est défini comme : tan *δ* = *ε"* / *ε*'.

La permittivité diélectrique complexe des charges actives, donc de la structure les intégrant, peut être modifiée par application d'une commande adaptée, de manière à faire varier les propriétés d'absorption et de réflexion par la structure composite d'ondes électromagnétiques incidentes sur ce substrat composite.

En particulier, la permittivité électrique complexe des charges actives dépend de la commande appliquée aux charges. La permittivité diélectrique complexe des charges actives est donc modifiable par application d'une commande.

Si le matériau est piézoélectrique seulement, i.e. ne présente pas de propriétés pyroélectriques, et donc pas de propriétés ferroélectriques, la permittivité diélectrique complexe des charges actives est modifiable par application d'une commande mécanique.

Si le matériau est en outre pyroélectrique, la permittivité diélectrique complexe des charges actives est modifiable par application d'une commande mécanique, thermique ou optique.

Si le matériau est en outre ferroélectrique, la permittivité diélectrique complexe des charges actives est modifiable par application d'une commande mécanique, thermique, optique ou électrique.

De préférence, les charges actives sont réalisées en un matériau ferroélectrique, qui a donc également des propriétés piézoélectriques et pyroélectriques.

Ainsi, la permittivité électrique complexe des charges actives est modifiable par application d'une commande électrique, une commande thermique, une commande optique, et/ou une commande mécanique.

Les charges actives sont par exemple dispersées dans l'ensemble du substrat. Dans ce cas, les caractéristiques diélectriques de l'ensemble de la structure composite sont reconfigurables. En particulier, les charges actives sont par exemple dispersées de manière uniforme dans le substrat.

En variante, les charges actives sont dispersées localement, dans une portion localisée ou plusieurs portions localisées du substrat composite. Dans ce cas, les caractéristiques diélectriques de la ou des portion(s) de la structure composite comprenant des charges actives sont reconfigurables. Dans cette portion ou dans chacune de ces portions, les charges actives sont par exemple dispersées de manière uniforme.

Les charges actives sont par exemple formées d'un matériau ferroélectrique qui est de préférence est choisi parmi la famille des perovskites, la famille ilménites, la famille des pyrochlores, la famille des bronzes quadratique, la famille des phases d'Aurivillius, le matériau choisi éventuellement dopé.

Notamment, le matériau ferroélectrique est par exemple un matériau de la famille des perovskites, par exemple BaTiO₃, CaTiO₃, KTaO₃, YMnO₃, PbTiO₃, etc.

Le matériau ferroélectrique peut également être :
- un ilménite, par exemple LiNbO₃,
- un pyrochlore, notamment Cd₂Nb₂O₇,
- un bronze quadratique, notamment PbNb₂O₆,
- une phase d'Aurivillius, notamment BiTi₃O₁₂ ou SrBi₂Ta₂O₉, etc.

Le matériau ferroélectrique peut être une phase dopée d'un des matériaux ci-dessus, par exemple Ba₁₋ₓSrTiO₃, KTa₁₋ₓNbₓTiO₃, AgTa₁₋ₓNbₓO₃, Sr₁₋ₓBiₓTiO₃, Pb₁₋ₓSrₓTiO₃, BaZr₁₋ₓTiₓO₃ etc.

La valeur du coefficient x peut être choisie entre 0 et 1, en fonction notamment de la température de Curie souhaitée pour le matériau.

Le matériau ferroélectrique peut également être un matériau multiferroïque, par exemple BiFeO₃, présentant plusieurs propriétés ferroïques. Par exemple, le matériau est à la fois ferroélectrique, ferroélastique et ferromagnétique.

Plusieurs matériaux ferroélectriques peuvent être combinés. Les charges actives sont alors constituées d'un mélange d'au moins deux matériaux ferroélectriques.

Par ailleurs, plusieurs matériaux pyroélectriques, ou plusieurs matériaux piezoélectriques, peuvent être combinés.

La commande, notamment électrique, thermique, optique ou mécanique, peut être appliquée à l'ensemble de la structure composite, de manière à commander les caractéristiques diélectriques de manière uniforme dans l'ensemble de la structure composite, ou à une portion seulement de la structure composite, de manière à commander les caractéristiques diélectriques de cette portion de la structure composite, indépendamment du reste de la structure composite. Bien entendu, une commande différente peut être appliquée au reste de la structure composite.

En particulier, une commande électrique comprend l'application d'une différence de potentiel électrique à au moins une portion de la structure composite, par exemple une différence de potentiel imposée entre les deux faces de la structure composite, résultant en une modification de la permittivité électrique complexe des charges actives, donc de la portion sélectionnée de la structure composite ou de l'ensemble de la structure composite.

Une commande thermique est réalisée en imposant à au moins une portion de la structure composite une température donnée, résultant en une modification de la permittivité électrique complexe des charges actives dans cette portion. Pour permettre une telle commande thermique, la structure composite peut être associée, par exemple, à une ou plusieurs résistances disposées sur le pourtour de la structure composite.

Une commande optique est par exemple réalisée en dirigeant une source optique, par exemple une source laser, sur une portion localisée de la structure composite ou sur l'ensemble de la structure composite, de manière à générer dans la portion localisée, ou dans l'ensemble de la structure, une élévation de la température, résultant en une modification de la permittivité électrique complexe des charges actives dans cette portion localisée ou dans l'ensemble de la structure composite.

Une commande mécanique comprend l'application d'une contrainte mécanique, en compression ou en traction, à une portion localisée ou à l'ensemble de la structure composite, résultant en une modification de la permittivité électrique complexe des charges actives dans cette portion localisée ou dans l'ensemble de la structure composite.

Si le matériau ferroélectrique est également ferromagnétique (matériau multiferroïque), les caractéristiques magnétique de la structure composite sont également modifiables par application d'une commande magnétique.

De manière générale, la commande est appliquée par un dispositif de commande, qui est configuré pour appliquer une commande électrique, thermique, mécanique, optique et/ou magnétique à la structure, à la portion de la structure composite contenant les charges actives, ou à une partie sélectionnée de la structure composite.

L'utilisation d'une commande thermique est plus particulièrement adaptée pour contrôler les caractéristiques diélectriques globales de la structure composite, tandis que l'utilisation d'une commande optique ou électrique est en particulier adaptée pour faire varier localement les caractéristiques diélectriques de la structure composite.

Selon un premier mode de réalisation, illustré schématiquement sur la Figure 1, la structure composite 1 comprend un substrat composite 3 réalisé en un matériau composite monolithique.

Ce matériau composite monolithique comprenant une résine 5 d'imprégnation, formant la matrice du matériau composite, et un ensemble de renforts fibreux 7, qui assurent le renfort mécanique du substrat composite.

La résine 5 est de préférence une résine organique, thermodurcissable ou thermoplastique, par exemple une résine polymère telle qu'une résine époxyde, une résine polyester, vinylester, etc.

Les renforts 7 sont réalisés en un matériau organique ou inorganique. Il s'agit par exemple de fibres de verre ou de carbone.

La structure composite 1 comprend par ailleurs une pluralité de charges actives 9 qui sont dispersées dans le substrat composite 3. De préférence, les charges actives 9 sont dispersées, sous forme de poudre, dans la résine 5 d'imprégnation. Les charges actives 9 sont par exemple introduites par mélange dans la résine avant son durcissement.

Le taux de charges actives dispersées est choisi de manière à optimiser la reconfigurabilité de la structure composite 1, c'est-à-dire en quantité suffisante pour permettre une modification significative des caractéristiques diélectriques de la structure composite 1, tout en conservant à la résine ses performances mécaniques et surtout son aptitude à servir de matrice d'imprégnation aux renforts fibreux 7.

De préférence, le taux de charge, exprimé en pourcentage massique dans la matrice en résine, est compris entre 50% et 90%.

Une diminution du taux de charge en charges actives induit une diminution des propriétés de reconfigurabilité de la structure composite comprenant ces charges, tandis qu'une augmentation de ce taux de charge peut induire une fragilisation de la structure composite et la rendre plus difficile à réaliser.

En variante, les charges actives sont dispersées sous forme de poudre sur les renforts 7.

Selon un deuxième mode de réalisation, illustré de manière générale sur la Figure 2, la structure composite 11 comprend un substrat composite sandwich 13.

Le substrat composite sandwich 13 comprend une âme 15 interposée entre deux peaux 17.

L'âme 15 est par exemple réalisée en un matériau expansé ou mousse, qui est par exemple une mousse de polyéthersufone, de polycholrure de vinyl, de polyuréthane, de polyéthylène, de polystyrène, ou de polyméthacrylimide.

Selon un autre exemple, l'âme 15 est réalisée en un matériau présentant une structure alvéolaire de type nid d'abeilles, cette structure alvéolaire comprenant des parois transversales délimitant une pluralité d'alvéoles. Ces alvéoles sont par exemple traversantes, c'est-à-dire débouchent transversalement de part et d'autre de l'âme 15. La structure alvéolaire est par exemple réalisée en aluminium ou en un matériau thermodurcissable ou thermoplastique tel que du polypropylène, ou encore en papier aramide.

Chaque peau 17 est réalisée en un matériau rigide, par exemple en un matériau composite monolithique tel que décrit en référence au premier mode de réalisation, comprenant une résine d'imprégnation et un ensemble de renforts fibreux

La structure composite 11 comprend une pluralité de charges actives qui sont dispersés dans l'âme 15 et/ou dans au moins une des peaux 17.

Dans une première variante de ce deuxième mode de réalisation, l'âme 15 est réalisée en un matériau présentant une structure alvéolaire de type nid d'abeilles, et les charges actives sont dispersées dans l'âme 15, en particulier dans au moins une partie des alvéoles.

Ainsi, au moins un premier ensemble d'alvéoles, i.e. une partie des alvéoles, comprend des charges actives.

Par exemple, les charges actives sont introduites dans les alvéoles sous forme de poudre de matériau ferroélectrique. Dans ce cas, la poudre formée de charges actives est directement introduite dans les alvéoles.

En alternative, les charges actives sont introduites dans les alvéoles sous forme de poudre après frittage (céramique).

Les charges actives peuvent également être dispersées dans une résine organique ou dans un matériau expansé introduit(e) dans les alvéoles. Notamment, lorsque les charges actives sont dispersées dans une résine organique, comme décrit ci-dessus, le taux de charge en charges actives dans cette résine est choisi de manière à optimiser la reconfigurabilité de la structure composite 11.

Les alvéoles comportant de telles charges actives sont sélectionnées en fonction de l'application visée.

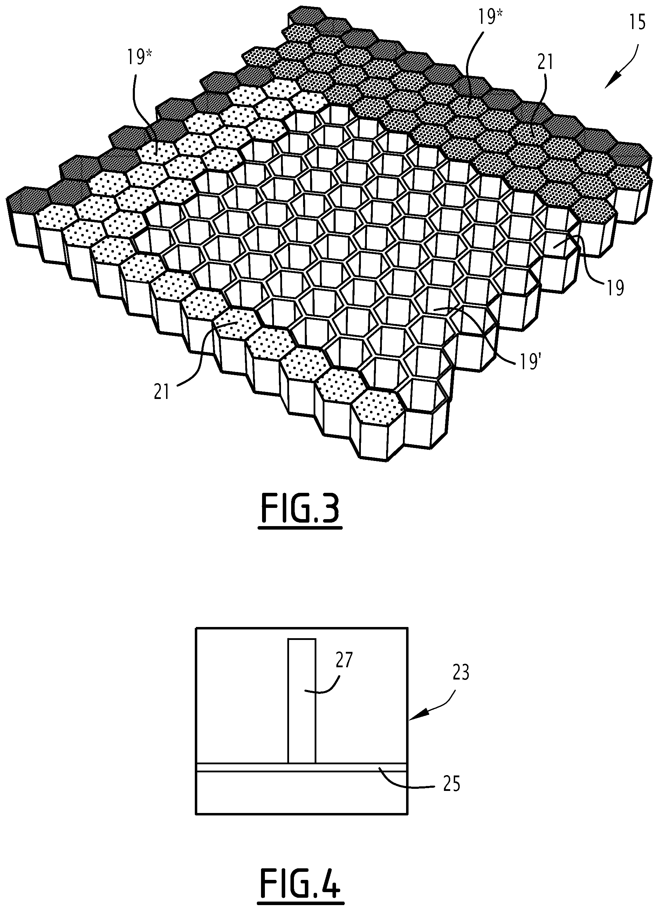

On a ainsi illustré sur la Figure 3, à titre d'exemple, une âme 15 d'un substrat composite sandwich comprenant une pluralité d'alvéoles 19, des charges actives 21 étant dispersées dans seulement un premier ensemble d'alvéoles, désignées par la référence 19^{*}, un deuxième ensemble d'alvéoles, désignées par la référence 19', ne comprenant pas de charges actives. L'insertion de charges actives dans un premier ensemble d'alvéoles seulement permet une commandabilité de la structure seulement dans des zones précises de cette structure.

Dans une deuxième variante de ce deuxième mode de réalisation, l'âme 15 est réalisée en un matériau expansé ou mousse, et les charges actives sont dispersées au sein de ce matériau expansé.

Les charges actives sont par exemple dispersées dans l'ensemble de la mousse formant l'âme 15. Dans ce cas, les caractéristiques diélectriques de l'ensemble de la structure composite 11 peuvent être configurées en modifiant les caractéristiques diélectriques des charges actives. Selon cet exemple, les charges actives sont par exemple introduites dans la mousse lors de la fabrication de celles-ci, ou introduites postérieurement dans des ouvertures préalablement réalisées.

Selon un autre exemple, les charges actives sont dispersées dans une portion seulement de la mousse, de telle sorte que seules les caractéristiques diélectriques de la portion correspondante de la structure composite 11 peuvent être reconfigurées.

Selon cet exemple, les charges actives sont par exemple introduites dans l'âme 15 dans des ouvertures préalablement réalisées.

Les charges actives sont par exemple introduites sous forme de poudre compacte ou frittée.

Dans une troisième variante de ce deuxième mode de réalisation, au moins une des peaux 17 est réalisée en un matériau composite monolithique comprenant une résine d'imprégnation et un ensemble de renforts fibreux.

Comme décrit ci-dessus en référence au premier mode de réalisation, la résine est par exemple une résine organique, thermodurcissable ou thermoplastique, par exemple une résine polymère telle qu'une résine époxyde, une résine polyester, vinylester etc., et les renforts sont par exemple des fibres de verre ou de carbone.

Dans cette troisième variante, la structure composite 11 comprend une pluralité de charges actives qui sont dispersées dans la ou les peaux 17 réalisées en un matériau composite monolithique, notamment dans la résine d'imprégnation et/ou sur les renforts de cette ou ces peaux, comme décrit ci-dessus en référence au premier mode de réalisation.

Les modes de réalisation et variantes décrites ci-dessus peuvent en outre être combinées.

En particulier, si le substrat composite est monolithique, une première partie des charges actives peut être dispersée dans la résine, et une deuxième partie sur les renforts.

En outre, si le substrat est un substrat composite sandwich, une partie des charges actives peut être dispersée dans l'âme du substrat, et une autre partie peut être dispersée dans une des peaux ou dans les deux peaux, notamment dans la résine et/ou sur les renforts de la ou des peaux.

A titre d'exemple, une structure composite 23 comprenant un substrat composite monolithique formé d'une résine époxyde et de renforts (non représentés), et des charges actives composées de titane de baryum-strontium BaₓSr₁₋ₓTiO₃, avec x=0,6 (BST), a été fabriquée.

Le BaₓSr₁₋ₓTiO₃, également appelé BST, présente une température de Curie Tc, délimitant la frontière entre l'état ferroélectrique du BST (T < Tc) et son état paraélectrique (T>Tc) d'environ 270 K. On sélectionnera la composition x de telle manière à placer la valeur de Tc à la température moyenne d'utilisation du matériau composite, i.e. là où la variation de la permittivité diélectrique complexe sera la plus importante. La partie réelle de la permittivité diélectrique du BST, ε', est maximale à la température T=Tc. Ainsi, une évolution de la température subie par le matériau autour de cette température entrainera une forte évolution des parties réelles et imaginaires de sa permittivité diélectrique, ε', ε", ainsi que de la tangente de pertes tanδ.

Pour fabriquer la structure composite, une céramique à l'état pulvérulent de BST a été mélangée à de la résine époxyde de qualité PRIME®27 et son durcisseur associé PRlME®20, dans les proportions massiques suivantes : 35,512 g de BST / 6,661 g de résine époxyde / 1,865 g de durcisseur. De telles proportions correspondent à une proportion massique en charges actives dans le substrat composite de 80,6%, ce qui correspond au maximum de poudre pouvant être introduit dans le mélange tout en conservant une répartition optimale de BST au sein de la matrice organique.

La résine a tout d'abord été mélangée au durcisseur, puis la poudre de BST a été introduite dans le mélange. Après homogénéisation, le mélange a été moulé sous forme d'une plaque carrée de dimension 50 mm x 50 mm x 2 mm. Le mélange, une fois moulé, a été laissé à température ambiante pendant une durée de 12 heures, induisant la polymérisation de la résine époxyde. La résine a ensuite été cuite à 65°C pendant une durée de 7 heures dans une étuve.

Afin de tester la commandabilité thermique de la structure ainsi obtenue, une ligne ruban 25 et un stub 27 ont été imprimés sur une surface de la structure composite, comme illustré de manière schématique sur la Figure 4.

Les caractéristiques hyperfréquences de la structure composite ont été mesurées au moyen d'un analyseur de réseaux, en faisant varier la température de 30°C à 200°C par exemple à l'aide d'une étuve ou autre moyen permettant de porter la température au niveau exigé.

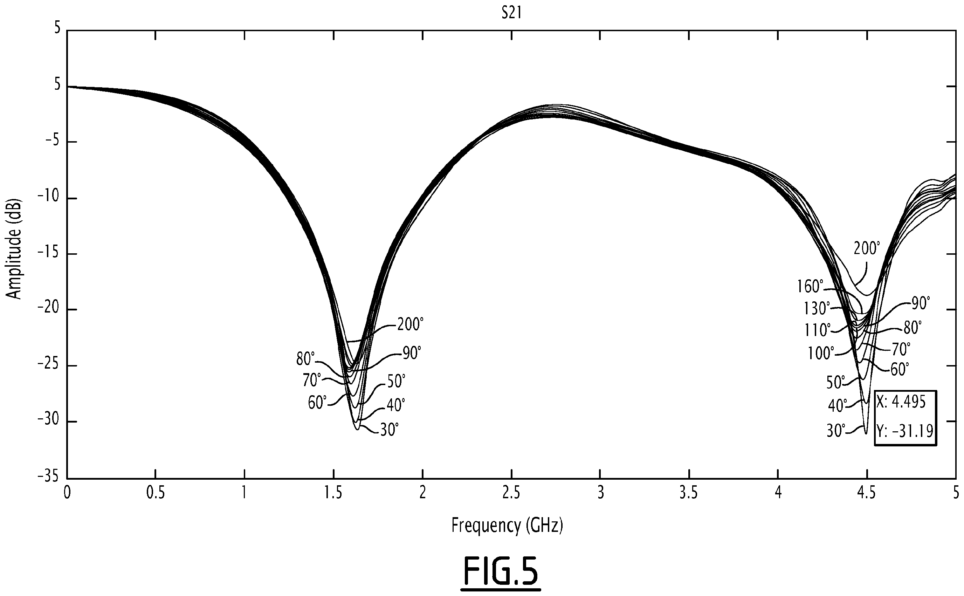

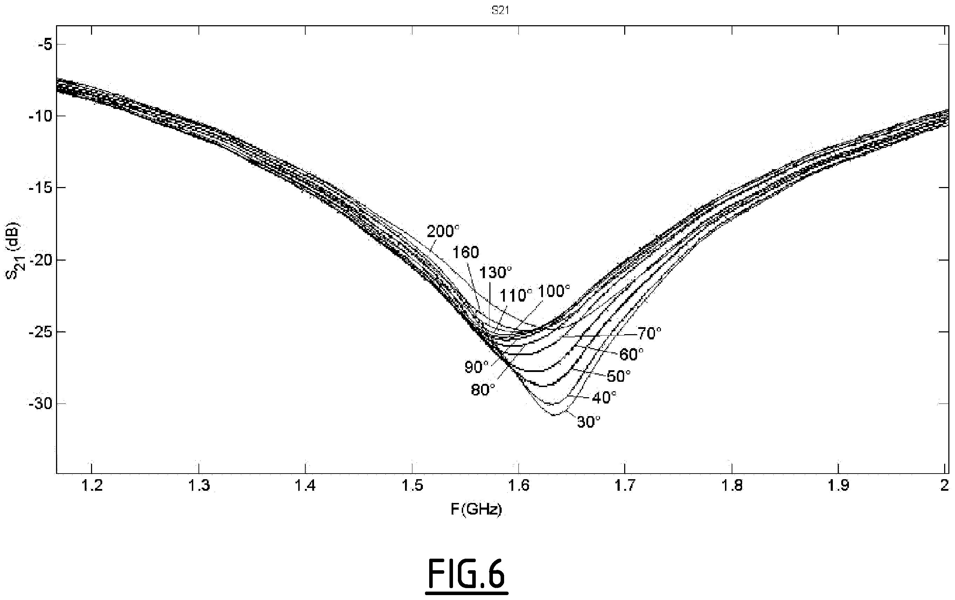

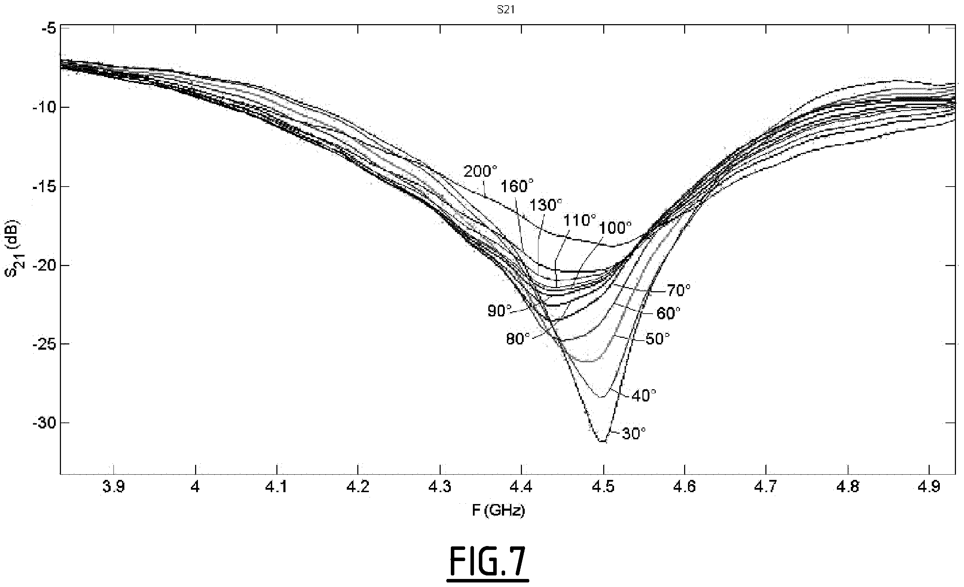

Le coefficient de transmission S₂₁ ainsi mesuré en fonction de la température et de la fréquence notée F (en GHz), exprimé en décibels (dB), a été illustré sur la Figure 5, et sur les Figures 6 et 7 qui représentent plus précisément les gammes de fréquence centrées sur le premier pic et le deuxième pic de résonance respectivement.

Sur ces Figures est représenté le coefficient de transmission S₂₁ mesuré à 30°C, 40°C, 50°C, 60°C, 70°C, 80°C, 90°C, 100°C, 110°C, 130°C, 160°C et 200°C. De manière générale, le coefficient de transmission S₂₁, exprimé en dB, aux premier et deuxième pics est une fonction décroissante de la température.

Comme illustré sur ces Figures, une variation de l'atténuation entre 30°C et 200°C pouvant atteindre 12,43 dB à 4,5 GHz, et une agilité en fréquence de +/- 60 MHz autour de la fréquence 4,5 GHz ont été mesurées.

Ces essais démontrent donc qu'une modification significative des caractéristiques hyperfréquences de la structure composite, résultant d'une modification de ses caractéristiques diélectriques, est effectivement obtenue en appliquant une commande thermique à la structure composite.

L'évolution thermique des caractéristiques diélectriques, notamment de la partie réelle ε' de la permittivité diélectrique et de la tangente de pertes, ont été déterminées par rétro-simulation. En particulier, en simulant la ligne microruban sur son substrat commandable à l'aide d'un logiciel de simulation électromagnétique (type CST studio par exemple), il est possible d'obtenir les paramètres Sᵢⱼ. En modifiant les caractéristiques diélectriques du substrat utilisé dans la simulation, nous pouvons confronter les paramètres Sᵢⱼ obtenus en simulation à celles de la mesure. Cette comparaison permet ainsi de remonter à la permittivité diélectrique et la tangente de pertes du composite commandable et cela pour différentes températures. En particulier, il a été déterminé que la partie réelle ε' de la permittivité diélectrique varie de ε'=14 à 30°C à ε'=15 à 80°C, puis à nouveau ε'=14 à 200°C. La tangente de pertes tanδ varie de tanδ=0,04 à 30°C à tanδ=0,09 à 80°C, puis à tanδ=0,14 à 200°C.

Les courbes de variation du coefficient de transmission S₂₁ à 30°C, 80°C et 200°C, déterminées à partir de ces valeurs, sont conformes aux courbes mesurées telles qu'illustrées sur les Figures 5 à 7.

Selon un deuxième exemple, une structure composite comprenant un substrat composite sandwich comprenant une structure alvéolaire de type nid d'abeilles, et des charges actives composées de résine époxyde chargée de poudre de titane de baryum-strontium BaₓSr₁₋ₓTiO₃, avec x=0,6, a été fabriquée.

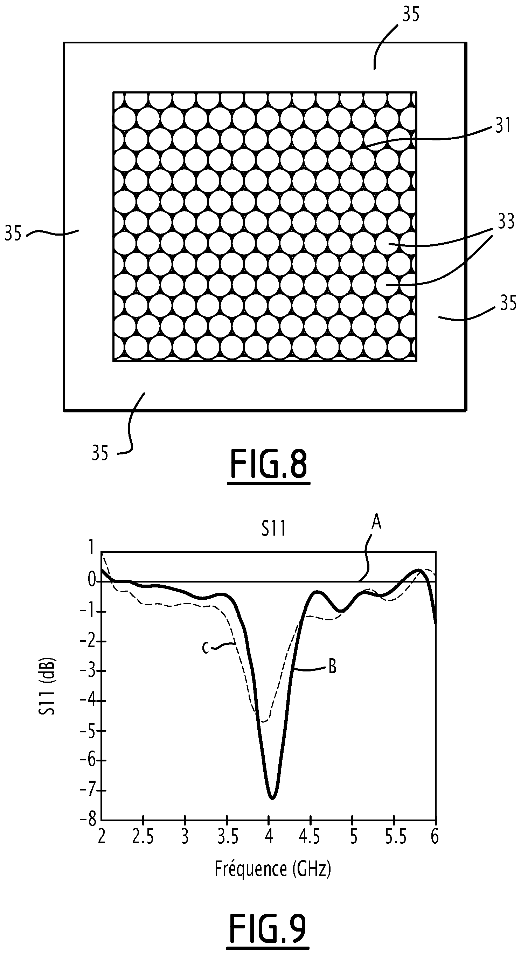

La structure alvéolaire 31, illustrée sur la Figure 8, est constituée de 12 x 12 alvéoles circulaires de 13,4 mm de diamètre. Une alvéole sur 4 a été remplie d'une résine époxy préalablement chargée à 80,6% en masse de Ba_{0,6}Sr_{0,4}TiO₃. Les alvéoles remplies de résine chargée en BST, désignées par la référence 33 sur la Figure 8, sont disjointes deux-à-deux.

La structure alvéolaire ainsi chargée est destinée à être associée à deux peaux réalisées en un matériau composite monolithique. Néanmoins, les caractéristiques hyperfréquences de la structure alvéolaire chargée ont été étudiées en l'absence des peaux monolithiques, afin de déterminer plus finement ces caractéristiques et leur évolution.

Dans un premier temps, les caractéristiques hyperfréquences d'une structure alvéolaire ne comprenant aucune charge active ont été déterminées, à titre de comparaison, en intercalant la structure alvéolaire non chargée entre deux cornets (un cornet émetteur d'ondes électromagnétiques et un cornet récepteur), et en mesurant le coefficient de réflexion S₁₁. Ce coefficient de réflexion S₁₁, exprimée en décibels, est nul, les ondes électromagnétiques étant totalement réfléchies par la structure alvéolaire non chargée.

Afin de tester la commandabilité thermique de la structure ainsi obtenue, quatre résistances chauffantes 35 ont été disposées sur la cadre de la structure alvéolaire.

Les caractéristiques hyperfréquences de la structure alvéolaire chargée ont par ailleurs été déterminées à 25°C, puis à 75°C (en chauffant la structure alvéolaire au moyen des résistances chauffantes 35), en intercalant la structure alvéolaire chargée entre deux cornets (un cornet émetteur d'ondes électromagnétiques et un cornet récepteur), et en mesurant le coefficient de réflexion S₁₁ des ondes électromagnétiques entre 2 GHz et 6 GHz.

Le coefficient de réflexion S₁₁ ainsi mesuré est illustré sur la Figure 9. Sur cette Figure, la courbe A illustre le coefficient de réflexion S₁₁ de la structure alvéolaire non chargée, la courbe B représente le coefficient de réflexion S₁₁ de la structure alvéolaire chargée à une température de 25°C, tandis que la courbe C représente le coefficient de réflexion S₁₁ de la structure alvéolaire chargée à une température de 75°C.

On constate que lorsque la structure alvéolaire comprend des charges actives, les ondes électromagnétiques sont partiellement transmises à travers la structure alvéolaire.

On note notamment l'apparition d'une fenêtre fréquentielle centrée à 4,05 GHz, avec S₁₁=-7,3dB, lorsque la structure alvéolaire chargée est à une température de 25°C.

Lorsque la température de cette structure alvéolaire est élevée à 75°C, la fenêtre fréquentielle est déplacée à une plus basse fréquence, centrée à 3,94 GHz, et le coefficient de réflexion S₁₁ augmente (S₁₁=-4,7dB).

Cet essai illustre ainsi que l'inclusion dans certaines alvéoles de la structure alvéolaires permettent d'obtenir des caractéristiques diélectriques de cette structure qui peuvent être modifiées par application d'une commande thermique.

Une telle structure alvéolaire, lorsqu'elle est associée à deux peaux pour former une structure composite, peut donc être utilisée comme structure active reconfigurable en fonction des caractéristiques hyperfréquences souhaitées.

Bien entendu, une telle reconfigurabilité pourrait également être obtenue en appliquant à la structure une commande électrique, optique ou mécanique.

Les structures composites selon l'invention présente ainsi des caractéristiques diélectriques qui sont commandables et reconfigurables en fonction de l'application visée, tout en étant adaptées pour une utilisation à grande échelle, par exemple en tant que panneau structural, notamment d'un porteur naval, terrestre ou aérien, et à plus faible échelle.

Par ailleurs, le surcoût lié à l'intégration des charges actives dans le substrat composite est modéré, ce qui permet de conférer à un système intégrant une telle structure des caractéristiques diélectriques reconfigurables à moindre coût.

En outre, la structure composite selon l'invention conserve les caractéristiques premières du substrat composite dans lesquelles les charges sont dispersées, en particulier en termes de légèreté, de rigidité mécanique, de résistance à la corrosion etc...

Les structures composites selon l'invention apportent un caractère modulable aux performances électromagnétiques des systèmes les intégrant.

En particulier, les structures composites à caractéristiques diélectriques reconfigurables selon l'invention, associées à un dispositif de commande adapté, peuvent être intégrées dans divers systèmes, tels que des systèmes antennaires dédiés à des applications de communications, notamment navales (dans des bâtiments de surface, des mâtures) ou terrestres (au sein de véhicules, de bâtiments) ou aéronautiques ou encore spatiales.

Ces structures composites peuvent également être utilisées :
- en tant que paroi de radôme actif, associé à une antenne, et/ou en tant que structure porteuse, par exemple une structure porteuse d'une antenne,
- en tant que paroi structurale d'un porteur naval, terrestre ou aérien intégrant une antenne,
- dans un brouilleur, une carte électronique, un déphaseur, un filtre, dans un radar ou un goniomètre,
- en tant que substrat d'un circuit imprimé dans le domaine électronique.

L'utilisation de structures composites selon l'invention, dont les caractéristiques diélectriques sont reconfigurables, et qui sont donc actives au contraire des structures composites généralement utilisées, permet d'apporter aux systèmes les intégrant de nouvelles fonctionnalités, et permet un rallongement de la durée de vie de ces systèmes, en permettant notamment d'adapter ces systèmes à de nouveaux besoins.

## Revendications

1. Structure composite (1 ; 11) à caractéristiques diélectriques reconfigurables, ladite structure composite (1 ; 11) comprenant un substrat composite (3 ; 13) et une pluralité de charges actives (9 ; 21) dispersées dans ledit substrat composite (3 ; 13), chaque charge active (9 ; 21) étant constituée d'un matériau ayant des caractéristiques diélectriques modifiables par application d'une commande à ladite structure composite (1 ; 11),
ledit substrat composite (13) est un substrat composite sandwich comprenant au moins une âme (15) interposée entre deux peaux (17), au moins une partie desdites charges actives (21) étant dispersée dans ladite âme (15), ladite âme (15) comprenant une couche de matériau présentant une structure alvéolaire comprenant des parois transversales délimitant une pluralité d'alvéoles (19),
ladite structure composite (1 ; 11) étant **caractérisée en ce qu'**au moins une partie desdites charges actives est dispersée dans au moins un premier ensemble d'alvéoles (19), un deuxième ensemble d'alvéoles étant dépourvu de charges actives.

2. Structure composite (1 ; 11) selon la revendication 1, **caractérisée en ce que** ledit matériau est choisi parmi :
- la famille des matériaux piézoélectriques, les caractéristiques diélectriques du matériau étant modifiables par application d'une commande mécanique,
- la famille des matériaux pyroélectriques, les caractéristiques diélectriques du matériau étant modifiables par application d'une commande mécanique, thermique et/ou optique,
- la famille des matériaux ferroélectriques, les caractéristiques diélectriques du matériau étant modifiables par application d'une commande mécanique, thermique, optique et/ou électrique.

3. Structure composite (1 ; 11) selon la revendication 2, **caractérisée en ce que** ledit matériau est choisi parmi la famille des matériaux multiferroïques.

4. Structure composite (1 ; 11) selon l'une quelconque des revendications 1 à 3, **caractérisée en ce que** ledit substrat composite (3 ; 13) comprend au moins une couche (3 ; 17) en un matériau composite monolithique, ledit matériau composite monolithique incluant une résine (5) et un ensemble de renforts (7).

5. Structure composite (1 ; 11) selon la revendication 4, **caractérisée en ce que** lesdites charges actives (9 ; 21) sont dispersées dans ladite résine (5) et/ou sur lesdits renforts (7) de ladite au moins une couche (3 ; 17).

6. Structure composite (11) selon l'une quelconque des revendications 1 à 5, **caractérisée en ce qu'**au moins une desdites peaux (17) est réalisée en un matériau composite monolithique, ledit matériau composite monolithique comprenant une résine et un ensemble de renforts, au moins une partie desdites charges actives étant dispersée dans ladite résine et/ou sur lesdits renforts.

7. Structure composite (11) selon l'une quelconque des revendications 1 à 6, **caractérisé en ce que** ladite âme (15) comprend une couche réalisée en un matériau expansé.

8. Structure composite (11) selon la revendication 7, **caractérisé en ce qu'**au moins une partie desdites charges actives est dispersée dans ledit matériau expansé.

9. Structure composite (1 ; 11) selon l'une quelconque des revendications précédentes, **caractérisée en ce que** ledit matériau est choisi parmi la famille des perovskites, la famille des ilménites, la famille des pyrochlores, la famille des bronzes quadratique, la famille des phases d'Aurivilius, ledit matériau étant éventuellement dopé.

10. Ensemble comprenant une structure composite (1 ; 11) selon l'une quelconque des revendications 1 à 9 et un dispositif de commande configuré pour appliquer une commande, notamment électrique, thermique, mécanique, optique et/ou magnétique à ladite structure composite (1 ; 11) en vue de modifier les propriétés diélectriques dudit matériau.

## Patentansprüche

1. Verbundstruktur (1; 11) mit rekonfigurierbaren dielektrischen Eigenschaften, wobei die Verbundstruktur (1; 11) **dadurch gekennzeichnet ist, dass** sie ein Verbundsubstrat (3; 13) und eine Mehrzahl von aktiven Füllstoffen (9; 21) aufweist, die in dem Verbundsubstrat (3; 13) verteilt sind, wobei jeder aktive Füllstoff (9; 21) aus einem Material mit dielektrischen Eigenschaften gebildet ist, die durch Anwendung einer Steuerung auf die Verbundstruktur (1; 11) modifiziert werden können,
wobei das Verbundsubstrat (13) ein Sandwich-Verbundsubstrat ist, das mindestens einen Kern (15) aufweist, der zwischen zwei Häuten (17) angeordnet ist, wobei mindestens ein Teil der aktiven Füllstoffe (21) in dem Kern (15) dispergiert ist, wobei der Kern (15) eine Schicht aus einem Material mit einer Wabenstruktur aufweist, wobei die Wabenstruktur Querwände aufweist, die eine Mehrzahl von Waben (19) begrenzen,
wobei die Verbundstruktur (1; 11) **dadurch gekennzeichnet ist, dass** mindestens ein Teil der aktiven Füllstoffe in mindestens einem ersten Satz von Waben (19) dispergiert ist, wobei ein zweiter Satz von Waben ohne aktive Füllstoffe ist.

2. Verbundstruktur (1; 11) nach Anspruch 1, **dadurch gekennzeichnet, dass** das Material ausgewählt ist aus:
- der Familie der piezoelektrischen Materialien, wobei die dielektrischen Eigenschaften des Materials durch Anwendung einer mechanischen Steuerung modifiziert werden können,
- der Familie der pyroelektrischen Materialien, wobei die dielektrischen Eigenschaften des Materials durch Anwendung einer mechanischen, thermischen und/oder optischen Steuerung modifiziert werden können,
- der Familie der ferroelektrischen Materialien, wobei die dielektrischen Eigenschaften des Materials durch Anwendung einer mechanischen, thermischen optischen und/oder elektrischen Steuerung modifiziert werden können.

3. Verbundstruktur (1; 11) nach Anspruch 2, **dadurch gekennzeichnet, dass** das Material aus der Familie der multiferroischen Materialien ausgewählt ist.

4. Verbundstruktur (1; 11) nach einem der Ansprüche 1 bis 3, **dadurch gekennzeichnet, dass** das Verbundsubstrat (3; 13) mindestens eine Schicht (3; 17) aus einem monolithischen Verbundmaterial aufweist, wobei das monolithische Verbundmaterial ein Harz (5) und einen Satz von Verstärkungen (7) enthält.

5. Verbundstruktur (1; 11) nach Anspruch 4, **dadurch gekennzeichnet, dass** die aktiven Füllstoffe (9; 21) in dem Harz (5) und/oder auf den Verstärkungen (7) der mindestens einen Schicht (3; 17) dispergiert sind.

6. Verbundstruktur (11) nach einem der Ansprüche 1 bis 5, **dadurch gekennzeichnet, dass** mindestens eine der Häute (17) aus einem monolithischen Verbundmaterial hergestellt ist, wobei das monolithische Verbundmaterial ein Harz und einen Satz von Verstärkungen aufweist, wobei mindestens ein Teil der aktiven Füllstoffe in dem Harz und/oder auf den Verstärkungen dispergiert ist.

7. Verbundstruktur (11) nach einem der Ansprüche 1 bis 6, **dadurch gekennzeichnet, dass** der Kern (15) eine Schicht aus einem expandierten Material aufweist.

8. Verbundstruktur (11) nach Anspruch 7, **dadurch gekennzeichnet, dass** mindestens ein Teil der aktiven Füllstoffe in dem expandierten Material dispergiert ist.

9. Verbundstruktur (1; 11) nach einem der vorstehenden Ansprüche, **dadurch gekennzeichnet, dass** das Material aus der Familie der Perowskite, der Familie der Ilmenite, der Familie der Pyrochlorverbindungen, der Familie der quadratischen Bronzen, der Familie der Aurivilius-Phasen ausgewählt ist, wobei das Material gegebenenfalls dotiert ist.

10. Anordnung, die eine Verbundstruktur (1; 11) nach einem der Ansprüche 1 bis 9 und eine Steuervorrichtung aufweist, die eingerichtet ist, eine Steuerung, insbesondere eine elektrische, thermische, mechanische, optische und/oder magnetische Steuerung, auf die genannte Verbundstruktur (1; 11) anzuwenden, um die dielektrischen Eigenschaften des genannten Materials zu modifizieren.

## Claims

1. Composite structure (1; 11) having reconfigurable dielectric characteristics, said composite structure (1; 11) comprising a composite substrate (3; 13) and a plurality of active fillers (9; 21) dispersed in said composite substrate (3; 13), each active filler (9; 21) being composed of a material having dielectric characteristics which are modifiable by application of a command to said composite structure (1; 11),
said composite substrate (13) is a sandwich composite substrate comprising at least one core (15) interposed between two skins (17), at least a portion of said active fillers (21) being dispersed in said core (15), said core (15) comprising a layer of material having a honeycomb structure comprising transverse walls delimiting a plurality of cells (19),
said composite structure (1; 11) being **characterised in that** at least a portion of said active fillers is dispersed in at least a first set of cells (19), a second set of cells being without active fillers.

2. Composite structure (1; 11) according to claim 1, **characterised in that** said material is chosen from:
- the family of the piezoelectric materials, the dielectric characteristics of the material being modifiable by application of a mechanical command,
- the family of the pyroelectric materials, the dielectric characteristics of the material being modifiable by application of a mechanical, thermal and/or optical command,
- the family of the ferroelectric materials, the dielectric characteristics of the material being modifiable by application of a mechanical, thermal, optical and/or electrical command.

3. Composite structure (1; 11) according to claim 2, **characterised in that** said material is chosen from the family of the multiferroic materials.

4. Composite structure (1; 11) according to any one of claims 1 to 3, **characterised in that** said composite substrate (3; 13) comprises at least one layer (3; 17) of a monolithic composite material, said monolithic composite material including a resin (5) and a set of reinforcements (7).

5. Composite structure (1; 11) according to claim 4, **characterised in that** said active fillers (9; 21) are dispersed in said resin (5) and/or on said reinforcements (7) of said at least one layer (3; 17).

6. Composite structure (11) according to any one of claims 1 to 5, **characterised in that** at least one of said skins (17) is made of a monolithic composite material, said monolithic composite material comprising a resin and a set of reinforcements, at least a portion of said active fillers being dispersed in said resin and/or on said reinforcements.

7. Composite structure (11) according to any one of claims 1 to 6, **characterised in that** said core (15) comprises a layer made of an expanded material.

8. Composite structure (11) according to claim 7, **characterised in that** at least a portion of said active fillers is dispersed in said expanded material.

9. Composite structure (1; 11) according to any one of the preceding claims, **characterised in that** said material is chosen from the family of the perovskites, the family of the ilmenites, the family of the pyrochlores, the family of the quadratic bronzes, the family of the Aurivilius phases, said material being optionally doped.

10. Assembly comprising a composite structure (1; 11) according to any one of claims 1 to 9 and a control device configured to apply a command, especially an electrical, thermal, mechanical, optical and/or magnetic command, to said composite structure (1; 11) in order to modify the dielectric properties of said material.
